# EUROPÄISCHE PATENTSCHRIFT

(11) **EP 3 365 973 B1**
(45) Veröffentlichungstag und Bekanntmachung des Hinweises auf die Patenterteilung: **14.08.2024**
(21) Anmeldenummer: 16784174.1
(22) Anmeldetag: 18.10.2016
(51) Int. Cl.: H02S 20/00, H02S 40/42

(54) **RÜCKSEITENELEMENT FÜR EIN SOLARMODUL**
REAR FACE ELEMENT FOR A SOLAR MODULE
ÉLÉMENT ARRIÈRE POUR MODULE SOLAIRE

(30) Priorität: 19.10.2015 DE 102015117793
(43) Veröffentlichungstag der Anmeldung: 29.08.2018
(73) Patentinhaber: MATRIX Module GmbH, 44369 Dortmund (DE)
(72) Erfinder: BUSSE, Henning, 04105 Leipzig (DE); SCHERFF, Maximilian, 44369 Dortmund (DE)
(86) Internationale Anmeldenummer: PCT/EP2016/074997
(87) Internationale Veröffentlichungsnummer: WO 2017/067940

(56) Entgegenhaltungen:
- WO-A1-2009/143577
- DE-U1- 202008 013 755

## Beschreibung

Die vorliegende Erfindung betrifft ein Rückseitenelement für ein Solarmodul.

Gemäß dem Stand der Technik ist es bekannt, Solarmodule derart aufzubauen, dass eine Mehrzahl von ggf. mechanisch empfindlichen Solarzellen elektrisch miteinander verbunden und in einem Schichtsystem eingeschlossen werden. Durch das Schichtsystem, welches in der Regel ein transparentes Substrat, insbesondere ein Glassubstrat, und eine Rückseitenabdeckung (Backsheet), zwischen denen die Solarzellen angeordnet sind, umfasst, werden die Solarzellen vor mechanischen Beanspruchungen und Witterungseinflüssen geschützt. Dabei sind auch die elektrischen Verbinder der Solarzellen untereinander von dem Schichtsystem eingeschlossen.

Zwischen den genannten Schichten sind üblicherweise Folien aus EVA (Ethylenvinylacetat) oder einem anderen geeigneten Material eingebracht, so dass das Schichtsystem unter dem Einfluss von Wärme und Druck zusammenlaminiert werden kann.

Ein Solarmodul umfasst dabei elektrische Anschlüsse, mit welchem die von den Schichten umschlossenen Solarzellen von außen kontaktierbar sind. Dabei sind die Solarzellen in der Regel in Reihe geschaltet, um gewünschte Ausgangsspannungen bereitzustellen, und zudem sind meist mehrere elektrische Anschlüsse vorgesehen, um separate Kreise getrennt abgreifen zu können. Ein solches separates Abgreifen ist beispielsweise bei einer partiellen Verschattung der Solarmodule notwendig bzw. vorteilhaft. Daher liegt in der Regel eine Vielzahl von elektrischen Anschlüssen vor, die von außen kontaktierbar sein müssen.

Solarmodule gemäß dem Stand der Technik benötigen dabei einen relativ hohen Rahmen und eine dicke Glassubstratschicht (ca. 3,2mm), um die einwirkenden Kräfte aus der Fläche (Schnee, Wind) zunächst in den Rahmen und dann an den Klemmstellen in die Unterkonstruktion abzuleiten. Üblich sind derzeit 30mm bis 40mm Rahmenhöhe.

Auf das Modullaminat werden dafür an allen vier Seiten Rahmenelemente aufgeschoben und mit Tape oder Silikon nicht lösbar mit dem Modullaminat verbunden. Benachbarte Rahmenteile werden an den Rahmenecken kraftschlüssig miteinander verbunden, z.B. indem ein Winkel eingepresst wird. Das Rahmenprofil umgreift dabei das Modullaminat, so dass eine ca. 1mm hohe Stufe in Bezug zur Glasoberfläche entsteht.

Der Einsatz von Rahmenprofilen geht dabei mit einer Vielzahl von Nachteilen einher. Die umgreifende Glaseinfassung des Rahmens verursacht Glasverschmutzung und erzeugt durch lokale Verschattungen Ertragseinbußen. Diese wird in Kauf genommen bzw. die Reinigungszyklen werden entsprechend angepasst. Des Weiteren führt der hohe Rahmen zu einer geringen Packungsdichte beim Versandt und somit zu höheren Kosten. Zur Reduktion der Rahmenhöhe erfolgen daher aufwändige Simulationen und Versuche, um eine minimale Rahmenhöhe bei ausreichender Stabilität bereitstellen zu können.

Die Ableitung der Flächenlasten in den Rahmen hat eine zweiachsige Durchbiegung des Moduls zur Folge, die zu großen mechanischen Spannungen in den Zellen, besonders in der Modulmitte, führt. Die Module liegen nur an vier Punkten auf. Zudem liegt bei Verbiegung die neutrale Phase nicht ideal (jenseits der Zellebene) und ihre Position variiert über die Modulfläche. Eine über die Fläche inhomogene Verteilung von Zug und Druckspannungen auf die Zellen/Zellverbinder ist die Folge, die in einer zweiachsigen Durchbiegung (kugelförmig) resultieren kann, der die Solarzellen nicht folgen können. Dadurch entsteht eine erhöhte Gefahr von Zellbruch.

Um diesen entgegenzuwirken werden dickere Glassubstrate und/oder stabilere Rahmen eingesetzt, die wiederum mit höheren Kosten, einem höheren Gewicht, einem aufwendigeren Transport, usw. einhergehen. Auch ist die Rahmenmontage arbeits-, personal- und zeitaufwendig und erfolgt nicht bzw. nur teil-automatisiert, was den Fertigungsaufwand deutlich erhöht.

Zudem ist die rückseitige Wärmeabgabe ungünstig. Der Wirkungsgrad der Solarmodule sinkt bei höheren Temperaturen, so dass eine gute Kühlung effizienzsteigernd wirkt. Durch die geschlossenen Rahmenprofile werden jedoch Konvektionsströmungen gerade behindert. Insbesondere bei In- bzw. Aufdachinstallation mit geringem Abstand zur Dachfläche ist die Wärmeabfuhr bei Solarmodulen mit Rahmenmodulen daher schlecht und die Effizienz ist suboptimal.

Auch ist es nachteilig, dass für die Modulmontage spezielle Klammern erforderlich sind, die auf die Rahmenhöhe abgestimmt sein müssen, oder die höhenvariabel und somit teuer sind. Daher ist die Modulmontage mit Klammern vergleichsweise aufwendig/teuer, nicht nur im Hinblick auf das benötigte individuelle Material und die damit verbundenen Lagerkosten, sondern zusätzlich mit Bezug auf die benötigte Montagezeit.

Als Alternative wurden daher sogenannte Befestigungen mit Backrails und Centerrails entwickelt. Dabei werden stangenförmigen, kastenförmige, U- oder doppel-T-profilförmige oder anders ausgestaltete Backrails auf der Rückseite des Modullaminats befestigt.

Auch dies geht mit einer Vielzahl von Problemen einher. Die Backrails liegen ebenfalls nur an wenigen Punkten auf der Modulrückseite auf. Dadurch muss das Backrail vergleichsweise hoch aufbauen. Die hohen Backrails führen zu einer geringen Packungsdichte beim Versandt und somit zu hohen Transportkosten, vergleichbar den bekannten Rahmenmodulen.

Vergleichbar mit den Rahmenmodulen liegt auch bei den Backrail-Systemen bei Verbiegung die neutrale Phase nicht ideal (jenseits der Zellebene) und ihre Position variiert über die Modulfläche. Eine über die Fläche inhomogene Verteilung von Zug und Druckspannungen auf die Zellen/Zellverbinder ist die Folge, mit einem ebenfalls erhöhten Zellbruchrisiko. Die Railmontage erfolgt ausschließlich nach dem Laminationsprozess und erhöht somit die Fertigungsdauer und Kosten, da separate Prozessschritte notwendig sind.

Auch ist bei Backrails wiederum die rückseitige Wärmeabgabe suboptimal. Konvektionsströmungen werden durch die Rails behindert (wenigstens in einer Richtung). Insbesondere bei In- bzw. Aufdachinstallation mit geringem Abstand zur Dachfläche ist dann die Wärmeabfuhr schlecht. Wie bereits mit Bezug auf Rahmenmodule aufgeführt, ist eine gute Kühlung jedoch für den Wirkungsgrad der Solarmodule wichtig.

Zudem ist es aufwendig, die mit Backrails versehen Solarmodule zu befestigen. In der Regel werden zwei Backrails an einem Solarmodul verwendet. Diese sind beispielsweise mittig auf der Laminatrückseite angeordnet und werden insbesondere an den kurzen überstehenden Enden der Backrails befestigt, jedoch kann eine Befestigung auch an anderen Stellen entlang des Backrails erfolgen. Dies hat insbesondere den Nachteil, dass hohe Biegestrecken vorliegen, die eine größere Dimensionierung der Backrails bedingen.

Es ist somit aus dem Stand der Technik bekannt, Solarmodule entweder mit einem Rahmenmodul oder mit Backrails auszustatten. In beiden Varianten kann jedoch keine optimale Kühlung der Solarmodule erreicht werden und die Montage derselben ist aufwendig. Zudem bedingen die technischen Gegebenheiten entweder eine sehr stabile Rahmenkonstruktion mit einem dicken Glassubstrat oder Backrails mit einem hohen Durchmesser, um die auftretenden Kräfte aufzunehmen. In beiden Fällen liegt jedoch eine über die Fläche inhomogene Verteilung von Zug und Druckspannungen auf die Zellen/Zellverbinder vor, die in Zellbrüchen resultieren kann. Zudem wird durch den insgesamt hohen Durchmesser der Transport verteuert.

Aus DE 102009020426 A1, DE 202008013755 U1 und FR 2967817 A1 sind Rückseitenelemente für Solarmodule bekannt, die in unterschiedlichen Abständen von den Solarzellen angeordnete Materialbahnabschnitte aufweisen. Diese Rückseitenelemente sind ausschließlich durch ein Umformen ohne Einschnitte in das Material erzeugt und weisen dabei insbesondere den Nachteil auf, dass eine unvorteilhaft schlechte Kühlung des Solarmoduls realisiert ist. Die zur Kühlung verwendete Luft muss gemäß dieser aus dem Stand der Technik bekannten Ausführungsformen die komplette Länge bzw. Breite des Moduls durchströmen. Dies resultiert in einem höheren Strömungswiderstand und somit einem geringeren Luftaustausch und gleichsam wird der Temperaturgradient zwischen dem Solarmodul und der kühlenden Luft herabsetzt.

Besonders nachteilig an den bekannten Lösungen ist, dass die Rückseitenelemente sogar als Isolierung auswirken können und somit die Solarzellentemperatur höher sein kann als bei einem üblichen Modul mit Standardrahmen.

Da der Umwandlungswirkungsgrad mit steigender Solarzellentemperatur abnimmt ist dies ein relevanter Effekt, der besonders nachteilig ist.

Der vorliegenden Erfindung liegt daher die Aufgabe zugrunde, die Nachteile des Stands der Technik zu überwinden und insbesondere eine Vorrichtung zur Aufnahme der auf die Solarmodule wirkenden Kräfte und zur Befestigung derselben zu liefern, die eine effiziente Produktion und Montage, eine gute Kühlung und reduzierte Transportkosten von Solarmodulen ermöglicht.

Diese Aufgabe wird gelöst durch ein Rückseitenelement für ein Solarmodul gebildet aus einer umgeformten, abschnittsweise eingeschnittenen, insbesondere geprägten und/oder gestanzten, Materialbahn, wobei die Materialbahn abschnittsweise in einer ersten Ebene und abschnittsweise in mindestens einer zu der ersten Ebene parallelen zweiten Ebene angeordnet ist, und wobei die Materialbahn im Übergangsbereich von der ersten in die zweite Ebene Beabstandungselemente ausbildet, um die erste von der zweiten Ebene zu beabstanden, und wobei sich mindestens ein erster Materialbahnabschnitt durchgängig, insbesondere linear verlaufend, von einem ersten Seitenrand zu einem gegenüberliegenden zweiten Seitenrand der Materialbahn in der ersten Ebene erstreckt, wobei n erste Materialbahnabschnitte, mit n = 1, 2, 3, 4, 5, 6, 7, 8, 9 oder mehr, sich von einem ersten Seitenrand zu einem gegenüberliegenden zweiten Seitenrand der Materialbahn in der ersten Ebene erstrecken und/oder m zweite Materialbahnabschnitte, mit m = 1, 2, 3, 4, 5, 6, 7, 8, 9 oder mehr, sich von einem dritten Seitenrand der Materialbahn zu einem gegenüberliegenden vierten Seitenrand in der ersten Ebene erstrecken, wobei die ersten und zweiten Materialbahnabschnitte rechtwinklig zueinander verlaufen, und wobei die aus der Materialbahn durch Umformen und Einschneiden erzeugten Materialbahnabschnitte mindestens abschnittsweise in denjenigen Bereichen, in denen diese nicht in der selben Ebene liegen, Öffnungen des Rückseitenelements ausbilden.

Unter Prägen und Stanzen soll im Rahmen der vorliegenden Erfindung nicht ausschließlich die konventionelle mechanische Metallbearbeitung verstanden werden, sondern gleichsam alle bekannten Trennverfahren, beispielsweise Laserscheiden oder Wasserstrahlschneiden, Fexen und dergleichen.

Das lineare Verlaufen der Materialbahnschnitte soll dabei erfindungsgemäß insbesondere nicht ausschließen, dass gemäß einer Ausführungsform die Materialbahnabschnitte in-sich verdreht vorliegen.

*Unter parallelen Ebenen sollen im Rahmen der vorliegenden Erfindung nicht ausschließlich zwei lokal überall parallel Ebenen verstanden werden, sondern es kann der Abstand zwischen der ersten Ebene und der zweiten Ebenen auch lokal variieren. Es ist jedoch erfindungsgemäß bevorzugt, dass die Flächen im Mittel über die Modulfläche parallel ausgebildet sind.*

Das erfindungsgemäße Rückseitenelement kann dabei auf der Rückseite eines Solarmoduls angeordnet werden. Daher kann es gemäß einer Ausführungsform der vorliegenden Erfindung besonders vorteilhaft vorgesehen sein, dass keine umlaufende Rahmenkante entsprechend dem Stand der Technik ausgebildet wird und die damit einhergehenden Nachteile werden vermieden, insbesondere entfällt eine kritische Stelle, an der sich Schmutz ansammeln kann, der die Solarzellen verschattet und den Wirkungsgrad negativ beeinflusst. Es kann jedoch vorgesehen sein, dass die Materialbahn optional an den Kanten mittels mehrmaligem Umkantens eine Art Rahmen für das Solarmodul bilden. Der besagte erfindungsgemäße Rahmen hat dabei vorzugsweise die Höhe des Rückseitenelements, so dass die Nachteile des Stands der Technik vermieden werden können.

Das erfindungsgemäße Rückseitenelement weist dabei längs und/oder quer zur der Solarmodulebene verlaufende erste und/oder zweite Materialbahnabschnitte auf, die in der ersten, im montierten Zustand weiter von dem Solarmodul beabstandeten, Ebene verlaufen. Der Verlauf der Materialbahnabschnitte kann linear erfolgen, es sind jedoch auch sämtliche alternativen Verläufe denkbar, beispielsweise kurvenförmige und/oder gezackte Verläufe, um bestimmte Geometrien wie beispielsweise ein Wabenmuster auszubilden. Die Breite der Materialbahnabschnitte und der Abstand dieser zur Solarmodulebene kann dabei entlang der Materialbahnabschnitte variieren. Dadurch kann es ermöglicht werden, dass die Steifigkeit der Materialbahnabschnitte der späteren Belastung lokal angepasst werde können.

Durch die erfindungsgemäße Ausgestaltung der ersten Ebene wird bei Belastung (Flächenlast wie Wind, Schnee) die Last, anders als bei gerahmten Modulen, flächig aufgenommen. Dadurch kann die Aufbauhöhe des Moduls und der Durchmesser des Glassubstrats geringer ausfallen.

Des Weiteren kann das Solarmodul nicht nur an vier Punkten (wie beim gerahmte Modul oder auch bei Modulen mit BackRails), auf der Materialbahn aufliegen, die z.B. wie Längs- oder Querträger wirken, sondern entlang der Längs- oder Querträger. Die bei Flächenbelastung resultierende Verbiegung des Moduls erfolgt dabei nur orthogonal zur Auflage, also nur in einer Richtung und nicht wie beim gerahmten Modul in zwei Richtungen gleichzeitig. Der mechanische Stress auf die Zellen ist daher sehr viel geringer. Dies gilt insbesondere dann, wenn bei einer geschickten Kombination der Dicke des Glassubstrats mit der Ausgestaltung des Rückseitenelements (Höhe, Material, Materialstärke, Geometrie der Materialbahnen) die Neutrale Phase in die Zellebene gelegt wird.

Bei einer Befestigung der Solarmodule auf Solartrackern, die ein zentrales Rohr aufweisen, kann z.B. im Zentrum des Solarmoduls ein Sockel vorhanden sein, der das Modul zusätzlich unterstützt.

Da bei Belastung die Verbiegung nur in einer Richtung auftritt, kann sogar eine größere Verbiegung hingenommen werden, insbesondere dann, wenn sich die Neutrale Phase in der Zellebene befindet. In diesem Fall sind die Zellbruchraten ähnlich gering wie bei einem symmetrischen Glas/Glas-Modul, jedoch bei mit geringeren Kosten und einer besseren Kühlung.

Zudem werden aufgrund der Ausgestaltung des Rückseitenelements vergleichbar einem Streckmetallprofil oder in Form eines Streckmetallprofils lokale Belastungen (Verspannungen der Unterkonstruktion, Wind, etc.) innerhalb des Rückseitenelements sehr gut abgefedert. Diese Eigenschaft wird durch die genaue Ausformung der Streckung bestimmt und kann somit den Anforderungen angepasst werden.

Auch wirkt die zweite Ebene des erfindungsgemäßen Rückseitenelements als Wärmeleiteinrichtung und dient somit zur Kühlung der Solarmodule. Zum einen wird dabei die große Oberfläche des gesamten Materialbahn ausgenutzt, um die Wärme an die Umgebung abzugeben. Zum anderen liegt eine große Auflagefläche der zweiten Ebene auf der Rückseite der Solarmodule vor, so dass hier eine gute Ableitung der Wärme erfolgen kann.

Auch kann Luft durch das Rückseitenelement strömen und zur weiteren Kühlung beitragen. Durch die hohe Anzahl von Öffnungen und Streben zwischen den beiden Ebenen des Rückseitenelements entsteht dabei schon bei geringen Strömungsgeschwindigkeiten eine turbulente Strömung, die die Wärme besser ableitet.

Dies wird erfindungsgemäß durch die Einschnitte in der Materialbahn ermöglichen, aus der die Materialbahnschnitte gebildet werden. Dabei kann die kühlende Luft in den Bereichen zwischen zwei Materialbahnabschniten aus dem Bereich zwischen den beiden Ebenen eintreten und austreten, was einen wesentlich besseren Kühleffekt hervorruft als dies durch die aus dem Stand der Technik bereitgestellten Rückseitenelementen ermöglicht werden kann. Bei den Rückseitenelementen gemäß dem Stand der Technik muss die Luft die komplette Länge bzw. Breite des Moduls durchströmen, was, wie bereits ausgeführt, einerseits einen größeren Strömungswiderstand hervorruft und somit einen geringeren Luftaustausch und andererseit den Temperaturgradienten zwischen Modul und kühlender Luft herabsetzt, wobei diese sogar isolierend wirken können. Da der Umwandlungswirkungsgrad mit steigender Solarzellentemperatur abnimmt ist die erfindungsgemäße Lösung daher besonders vorteilhaft.

Ein erfindungsgemäße Rückseitenelement ermöglicht somit die Verwendung nur eines Bauteils, welches einfach, schnell und sicher mit einem Solarmodul verbindbar ist. Dabei kann das Rückseitenelement sogar während des Laminationsprozesses appliziert werden. Die erste solarmodulabgewandte Ebene nimmt die Zug- und Druckkräfte (bei Modulverbiegung) auf, die zweite Ebene bietet eine große Auflagefläche zur Wärmeabfuhr.

Zudem kann durch die bessere Aufnahme der auftretenden Kräfte die Dicke des Solarmoduls reduziert werden, sowohl im Hinblick auf die Schichten des Moduls, insbesondere des Glassubstrats, als auch im Hinblick auf die nicht benötigten Rahmenelemente und Backrails. Dies reduziert die Kosten weiter und optimiert die Transportmöglichkeiten.

Das erfindungsgemäße Rückseitenelement ist somit zur Aufnahme von auf Solarmodule wirkenden Kräften und zur Befestigung derselben in der Lage, ermöglicht eine effiziente Produktion und Montage, eine gute Kühlung und reduzierte Transportkosten von Solarmodulen.

Dabei kann insbesondere vorgesehen sein, dass die ersten Materialbahnabschnitte parallel zueinander angeordnet sind und/oder die zweiten Materialbahnabschnitte parallel zueinander angeordnet sind.

Auch kann vorgesehen sein, dass sich die n ersten Materialbahnabschnitte durchgängig, von einem ersten Seitenrand zu einem gegenüberliegenden zweiten Seitenrand der Materialbahn in der ersten Ebene erstrecken und/oder die m zweiten Materialbahnabschnitte sich durchgängig von einem dritten Seitenrand der Materialbahn zu einem gegenüberliegenden vierten Seitenrand in der ersten Ebene erstrecken.

Selbstverständlich sind auch andere Anordnungsvarianten denkbar und die Materialbahnabschnitte selbst können linear oder kurvenförmige oder in beliebiger Geometrie verlaufen. Auch kann vorgesehen sein, dass die zweite Ebene p, mit p = 1,2,3,4,5,6,7,8,9, oder mehr, flächige Elemente umfasst, die voneinander beabstandet angeordnet sind, und die insbesondere jeweils zwischen den n ersten und/oder m zweiten Materialbahnabschnitten der ersten Ebene angeordnet sind.

Durch eine Anordnung von rechtwinklig zueinander verlaufenden ersten und zweiten Materialbahnabschnitten können Bereiche definiert werden, die mittels Umformen in der zweite Ebene angeordnet sind. Dies kann gemäß einer Ausführungsform der vorliegenden Erfindung vorteilhaft ein.

Gemäß einer Ausführungsform der Erfindung kann bevorzugt sein, dass jedes der flächigen Elemente der zweiten Ebene mittels mindestens einem, insbesondere vier, Beabstandungselemente mit den ersten und/oder zweiten Materialbahnabschnitten der ersten Ebene verbunden ist, wobei die Beabstandungselemente durch Einschneiden und Umformen der Materialbahn gebildet sind.

Einschneiden soll im Sinne der vorliegenden Erfindung breit verstanden werden und das abschnittsweise oder vollständige Durchtrennen eines Materialbahnabschnitts oder einer Materialbahn bezeichnen. Hierzu sind im Stand der Technik eine Vielzahl von Trennverfahren bekannt.

Das erfindungsgemäße Rückseitenelement wird aus einer einzigen Materialbahn gebildet, so dass die Beabstandungselemente den Übergang zwischen erste und zweiter Ebene ausbilden. Die Beabstandungselemente sind insbesondere ausgelegt und eingerichtet, um eine Kraftübertragung von der ersten in die zweite Ebene zu ermöglichen. Auch kann vorgesehen sein, dass das Rückseitenelement q, mit q = 1,2,3,4,5,6,7,8,9, oder mehr, Zellen aufweist, wobei jeder der q Zellen aus zwei ersten Materialbahnabschnitten, zwei zweiten Materialbahnabschnitten in der ersten Ebene und einem flächigen Element in der zweiten Ebene gebildet ist.

Dabei ist es bevorzugt, dass ein erster erster Materialbahnabschnitt ein erstes Seitenende, ein zweiter erster Materialbahnabschnitt ein dem ersten Seitenende gegenüberliegendes zweites Seitenende, ein erster zweiter Materialbahnabschnitt ein rechtwinklig zu den ersten und zweiten Seitenenden angeordnetes drittes Seitenende und ein zweiter zweiter Materialbahnabschnitt ein dem dritten Seitenende gegenüberliegendes viertes Seitenende ausbildet, wobei durch Umformen ein erster Ausschnitt der Materialbahn beginnend bei dem zweiten zweiten Materialbahnabschnitt in einem ersten Abstand parallel zu dem ersten ersten Materialbahnabschnitt bis zu einer ersten Beabstandung zu dem ersten zweiten Materialbahnabschnitt und ein zweiter Ausschnitt der Materialbahn beginnend bei dem zweiten zweiten Materialbahnabschnitt in einem zweiten Abstand, größer als der erste Abstand, parallel zu dem ersten ersten Materialbahnabschnitt bis zu einer zweiten Beabstandung, größer als die erste Beabstandung, zu dem ersten zweiten Materialbahnabschnitt verläuft und/oder durch Umformen ein dritter Ausschnitt der Materialbahn beginnend bei dem ersten zweiten Materialbahnabschnitt in einem ersten Abstand parallel zu dem zweiten ersten Materialbahnabschnitt bis zu einer ersten Beabstandung zu dem zweiten zweiten Materialbahnabschnitt und ein vierter Ausschnitt der Materialbahn beginnend bei dem ersten zweiten Materialbahnabschnitt in einem zweiten Abstand, größer als der erste Abstand, parallel zu dem zweiten ersten Materialbahnabschnitt bis zu einer zweiten Beabstandung, größer als die erste Beabstandung, zu dem zweiten zweiten Materialbahnabschnitt verläuft, und/oder durch Umformen ein fünfter Ausschnitt der Materialbahn beginnend bei dem ersten ersten Materialbahnabschnitt in einem ersten Abstand parallel zu dem ersten zweiten Materialbahnabschnitt bis zu einer ersten Beabstandung zu dem zweiten ersten Materialbahnabschnitt und ein sechster Ausschnitt der Materialbahn beginnend bei dem ersten ersten Materialbahnabschnitt in einem zweiten Abstand, größer als der erste Abstand, parallel zu dem ersten zweiten Materialbahnabschnitt bis zu einer zweiten Beabstandung, größer als die erste Beabstandung, zu dem zweiten ersten Materialbahnabschnitt verläuft, und/oder durch Umformen ein siebter Ausschnitt der Materialbahn beginnend bei dem zweiten ersten Materialbahnabschnitt in einem ersten Abstand parallel zu dem zweiten zweiten Materialbahnabschnitt bis zu einer ersten Beabstandung zu dem ersten ersten Materialbahnabschnitt und ein achter Ausschnitt der Materialbahn beginnend bei dem zweiten ersten Materialbahnabschnitt in einem zweiten Abstand, größer als der erste Abstand, parallel zu dem zweiten zweiten Materialbahnabschnitt bis zu einer zweiten Beabstandung, größer als die erste Beabstandung, zu dem ersten ersten Materialbahnabschnitt verläuft, so dass mindestens ein, insbesondere vier, Beabstandungselemente zur Beabstandung eines flächigen Elementes von dem ersten und dem zweiten Materialbahnabschnitt innerhalb der Zelle ausgebildet ist.

Durch diese Anordnung in der Materialbahn kann es ermöglicht werden, dass eine Vielzahl von flächigen Elementen durch Einschneiden und Umformen aus der ersten Ebene in die zweite Ebene überführt werden, dort insbesondere parallel zu der ersten Ebene angeordnet sind, und gleichsam dritte Materialbahnabschnitte den Übergang von der ersten in die zweite Ebene ausbilden. Diese dritten Materialbahnabschnitte stellen dabei zudem die Beabstandungselemente bereit. Des Weiteren kann vorgesehen sein, dass die Materialbahn aus Metall, Edelstahl, Stahlblech, Eisenblech, Kupfer, Messing, Aluminium, Kunststoff, spritzgegossenem Kunststoff und/oder teilweise umspritzten Metall besteht und/oder dieses umfasst, und insbesondere eine Stärke in einem Bereich von 0,2mm bis 4mm, vorzugsweise in einem Bereich von 0,4mm bis 2mm, besonders bevorzugt in einem Bereich von 0,5mm bis 1 mm aufweist.

Auch kann es vorteilhaft sein, dass das Rückseitenelement in der ersten Ebene und/oder in der zweiten Ebene mindestens eine Aussparung aufweist, um eine Anschlussdose für eine elektrische Kontaktierung einer Solarzelle und/oder einer Solarzellenmatrix aufzunehmen und/oder um eine elektrische Kontaktierung einer Solarzelle und/oder einer Solarzellenmatrix, insbesondere der frei in der Aussparung liegenden Bereich der Querverbinder einer Solarzelle und/oder einer Solarzellenmatrix, zu ermöglichen.

Ein Solarmodul umfasst dabei elektrische Anschlüsse, mit welchem die von den Schichten umschlossenen Solarzellen von außen kontaktierbar sind. Dabei sind die Solarzellen in der Regel in Reihe geschaltet, um gewünschte Ausgangsspannungen bereitzustellen, und zudem sind meist mehrere elektrische Anschlüsse vorgesehen, um separate Kreise getrennt abgreifen zu können. Als Zellverbinder und Querverbinder werden u.a. metallische Bänder, z.B. Kupferbänder mit oder ohne zusätzliche Metall oder Legierungsbeschichtung, verwendet. Für jede Verbindung zwischen zwei elektrisch zu verbindenden Solarzellensträngen wird ein solches metallisches Band als gesonderter Querverbinder vorgesehen. Die Zellverbinder selbst werden dann mit dem Querverbinder verlötet. Zum Beispiel können vor dem Laminieren des Solarmoduls Anschlussfahnen zur Schaffung der elektrischen Anschlüsse aus der EVA-Rückseitenfolie herausgeführt werden. Nach der Lamination konnten dann Anschlusselemente wie Buchsen oder Stecker mit diesen nach aussen geführten Anschlussfahnen verbunden werden, z. B. durch Löten. Dafür wird z.B. eine Anschlussdose auf der Laminatrückseite mittels Silikon aufgeklebt und dann werden die Anschlussfahnen der Solarzellen mit den Kontakten der Anschlussdose elektrisch verbunden. Die Anschlussdose selbst kann nach erfolgter elektrischer Kontaktierung mit einem insbesondere durch Strahlung härtenden Material zur Versiegelung derselben befüllt werden und/oder optional ein dichtender Deckel über der Anschlussdose montiert werden.

indem das erfindungsgemäße Rückseitenelement bereits Aussparungen für die elektrische Kontaktierung und die Anschlussdosen aufweist, ist eine solche mit einfachen Mitteln und minimalem Aufwand möglich.

Weist das erfindungsgemäße Rückseitenelement nur Öffnungen für die Querverbinder auf, so ist der Bereich zwischen der Anschlussdose und Rückseite des Schichtlaminats mit dem wärmeleitfähigen Material der Materialbahn bedeckt und kann so zur besseren Wärmeableitung der Diodenabwärme dienen, die mit den Querverbindern kontaktiert sind. Auch kann vorgesehen sein, dass die Materialbahn Verstärkungselemente umfasst, insbesondere angeordnet im Verbindungsbereich des Rückseitenelements des Solarmoduls mit einer Unterkonstruktion. Dies dient der Versteifung des Rückseitenelements und erhöht dessen Stabilität.

Erfindungsgemäß kann auch vorgesehen sein, dass die zweite Ebene, insbesondere mindestens ein flächiges Element der zweiten Ebene, derart umgeformt ist, dass eine dritte Ebene ausgebildet ist und/oder eine umgeformte, insbesondere geprägte, Oberflächenstruktur aufweist, insbesondere wabenförmig ist.

Eine solche dritte Ebene und/oder Struktur der zweiten Ebene kann zum Beispiel einer weiter optimierten Kühlung dienen und nicht zur Verbesserung der mechanischen Steifheit.

Des Weiteren kann vorgesehen sein, dass die Kanten der Materialbahnen in Richtung der Zellebene gekantet sind. Dadurch werden Schnittverletzungen vermieden.

Auch kann vorgesehen sein, dass Halteösen, Klammern, Kabelführungen und/oder Kabelkanäle für die elektrische Kontaktierung der Solarzellen umfasst sind und/oder das Rückseitenelement Aussparungen im Randbereich aufweist, um einen sicheren Transport von elektrischen Kontaktelementen, insbesondere von Kabeln und/oder Steckern, zu ermöglichen sowie deren Befestigung nach der Solarmodulmontage zu vereinfachen/gewährleisten.

Diese Ausgestaltung ermöglich es, auf weiteres Montagematerial (Kabelbinder, etc.) verzichten zu können.

Des Weiteren kann vorgesehen sein, dass mindestens ein äußerer Rand, insbesondere zwei gegenüberliegende Ränder, vorzugsweise alle Ränder, des Rückseitenelements durch Abkanten umgeformt ist bzw. sind und insbesondere ein zur Versteifung geeignetes Profil ausbilden, insbesondere eine Kastenprofil.

Ein solches Abkanten dient der weiteren Versteifung des Rückseitenelements.

Gemäß einer Ausführungsform kann des Weiteren vorgesehen sein, dass mindestens ein äußerer Rand, insbesondere zwei gegenüberliegende Ränder, vorzugsweise alle Ränder, des Rückseitenelements Aussparungen und/oder Ausformungen umfassen, die mit komplementären Aussparungen und/oder Ausformungen eines weiteren Rückseitenelements in Wirkverbindung bringbar sind oder stehen, wobei die Aussparungen und/oder Ausformungen ausgelegt und eingerichtet sind, um zwei Rückseitenelemente gegeneinander auszurichten.

Dies ermöglicht ein leichtes Verbinden mehrerer Rückseitenelemente miteinander, ohne die aufwendige genaue manuelle Ausrichtung und unter einem Verzicht auf ein Nachmessen. Die Montagezeit kann somit deutlich verkürzt werden.

Auch kann vorgesehen sein, dass mindestens ein äußerer Rand, insbesondere zwei gegenüberliegende Ränder, vorzugsweise alle Ränder, des Rückseitenelements Befestigungseinrichtungen und/oder Aussparungen, insbesondere in Form von Bohrungen, aufweisen, ausgelegt und eingerichtet, um das Rückseitenelement mit einem weiteren Element und/oder der Unterkonstruktion nicht lösbar oder lösbar zu verbinden. Durch eine solche Ausgestaltung des Rückseitenelements ist es möglich, je nach Unterkonstruktion, das Rückseitenelement nur mit Schrauben, ohne weiteres Material (Klemmen), zu befestigen.

Schließlich kann vorgesehen sein, dass das Rückseitenelement aus einer umgeformten Materialbahn besteht.

Auch liefert die Erfindung ein Solarmodul umfassend mindestens zwei Solarzellen und mindestens ein auf der Rückseite der Solarzellen angeordnetes erfindungsgemäßes Rückseitenelement, wobei die zweite Ebene des mindestens einen Rückseitenelements der Rückseite der Solarzellen zugewandt angeordnet ist.

Dabei können ein oder mehrere Rückseitenelemente in Bahnen gleicher oder unterschiedlicher Länge so auf der Rückseite des Schichtverbunds positioniert werden, dass nicht das komplette Backsheet, sondern nur die relevanten, zu unterstützenden Bereiche damit beaufschlagt werden. Es ist z. B. möglich, spezifische Ausbildungen des erfindungsgemäßen Rückseitenelements für Tracker-System oder für ein spezielles Einschub-System vorzusehen. Eine optimale Anpassung der mechanischen Stabilität an die vorherrschende Einbausituation kann somit mit minimalem Materialeinsatz erfolgen. Es hat sich jedoch dabei als vorteilhaft erwiesen, wenn die Haupt-Zug-Druck-Richtung des Schichtsystems durch ein Rückseitenelement vollständig überdeckt wird, um die auftretenden Kräfte optimal aufnehmen zu können.

Dabei ist insbesondere vorgesehen, dass das Solarmodul keinen Modulrahmen und kein Montagesystem umfassend Backrails umfasst.

Auch kann vorgesehen sein, dass jeweils mindestens ein flächiges Element und/oder mindestens eine Zelle, insbesondere flächige Elemente und/oder Zellen, mit r = 1, 2, 3, 4, 5, 6, 7, 8, 9 oder mehr, vorzugsweise mit r = 1, 4, 9, oder 16, in der zweiten Ebene des Rückseitenelements zumindest teilweise überlappend, insbesondere deckungsgleich mit jeweils mindestens einer der Solarzellen der Solarzellenmatrix des Solarmoduls angeordnet ist, so dass der Rückseite jeder der Solarzellen r flächige Elemente und/oder Zellen gegenüberliegen.

Schließlich kann vorgesehen sein, dass das Rückseitenelement die gesamte Rückseite des Solarmoduls überdeckt oder mindestens ein oder mehr Rückseitenelemente einen Teilbereich der Rückseite des Solarmoduls überdeckt. Auch liefert die Erfindung ein Verfahren zur Herstellung eines Solarmoduls umfassend die folgenden Schritte, insbesondere in dieser Reihenfolge:
a) Bereitstellen einer Substratplatte;
b) Anordnen von mindestens zwei elektrisch miteinander kontaktierten Solarzellen auf der Substratplatte;
c) Anordnen mindestens einer rückseitigen Laminatschicht auf der Rückseite der Solarzelle;
d) Anordnen mindestens eines erfindungsgemäßen Rückseitenelements auf der rückseitigen Laminatschicht; und
e) Laminieren des Solarmoduls.

Dabei kann vorgesehen sein, dass das Verfahren weiterhin die nachfolgenden Schritte nach Schritte),
insbesondere in dieser Reihenfolge, umfasst:
f) Trimmen des Laminats; und
g) Setzen der Anschlussdosen zur elektrischen Kontaktierung des Solarmoduls.

Auch liefert die Erfindung ein alternatives Verfahren zur Herstellung eines Solarmoduls umfassend die folgenden Schritte, insbesondere in dieser Reihenfolge:
aa) Bereitstellen einer Substratplatte;
   ab) Anordnen von mindestens zwei elektrisch miteinander kontaktierten Solarzellen auf der Substratplatte;
   ac) Anordnen mindestens einer rückseitigen Laminatschicht auf der Rückseite der Solarzelle;
   ad) Laminieren mindestens der rückseitigen Laminatschicht;
   ae) optionales Trimmen des Laminats;
   af) optionales Setzen der Anschlussdosen zur elektrischen Kontaktierung des Solarmoduls und Anordnen mindestens eines erfindungsgemäßen Rückseitenelements auf der rückseitigen Laminatschicht und Verbinden des Rückseitenelements mit der rückseitigen Laminatschicht, insbesondere durch Silikon oder Polyurethan-Kleber; oder ag) Anordnen mindestens eines erfindungsgemäßen Rückseitenelements auf der rückseitigen Laminatschicht und Verbinden des Rückseitenelements mit der rückseitigen Laminatschicht, insbesondere durch Silikon oder Polyurethan-Kleber, und Setzen der Anschlussdosen zur elektrischen Kontaktierung des Solarmoduls.

Die erfindungsgemäßen Verfahren ermöglichen einen schnelleren, einfacheren und kostengünstigeren Herstellungsprozess von Solarmodulen.

Gemäß den konventionellen Herstellverfahren wird zunächst in der Regel auf ein Glassubstrat eine EVA-Schicht angeordnet, um eine Substratplatte zu bilden, auf der wiederum die Solarzellen angeordnete werden. Auf die Rückseite der Solarzellen wird eine erneute EVA-Schicht und das Backsheet, also die rückseitige Laminatschicht, aufgebracht und anschließend erfolgt ein Laminieren des Moduls. Nach dem Laminieren wird das Laminat getrimmt und die Anschlussdosen zur elektrischen Kontaktieren werden gesetzt.

Erst nach diesem Schritt werden die Rahmenelemente mit dem Schichtaufbau verbunden, in dem diese silikoniert und aufgesteckt werden. Gleichzeitig werden die Eckwinkel des Rahmens in die Rahmenelemente eingepresst.

Gemäß dem ersten erfindungsgemäßen Verfahren wird das erfindungsgemäße Rückseitenelement bereits während des Modulbaus mit der Modulrückseite verbunden, insbesondere an den Kontaktbereichen flächig verklebt. Dies ist wichtig für Wärmeableitung. Letzteres kann während des Laminierprozesses (Laminator, Autoklaven) erfolgen. Somit lassen sich im Vergleich zum klassischen Modul eine Reihe von Arbeitsschritten und Maschinen einsparen.

Alternativ kann ein solches Verkleben des Rückseitenelementes auch erst nach einem Laminieren des Moduls erfolgen. Auch in diesem Fall wird eine erhebliche Anzahl von Arbeitsschritten eingespart, da nur ein Verbindungsschritt notwendig ist.

Weitere Merkmale und Vorteile der Erfindung ergeben sich aus der nachfolgenden Beschreibung, in der Ausführungsbeispiele der Erfindung anhand von schematischen Zeichnungen beispielhaft erläutert werden, ohne dadurch die Erfindung zu beschränken. Dabei zeigt:
Figur 1: eine schematische perspektivische Ansicht einer ersten Ausführungsform eines erfindungsgemäßen Rückseitenelements;
Figur 2: eine schematische perspektivische Ansicht einer zweiten Ausführungsform eines erfindungsgemäßen Rückseitenelements;
Figur 3: eine schematische perspektivische Ansicht einer Ausführungsform eines weiteren erfindungsgemäßen Rückseitenelements und eines Solarmoduls; und
Figur 4: eine schematische Seitenansicht einer Ausführungsform des erfindungsgemäßen Rückseitenelements und des Solarmoduls gemäß Figur 3.

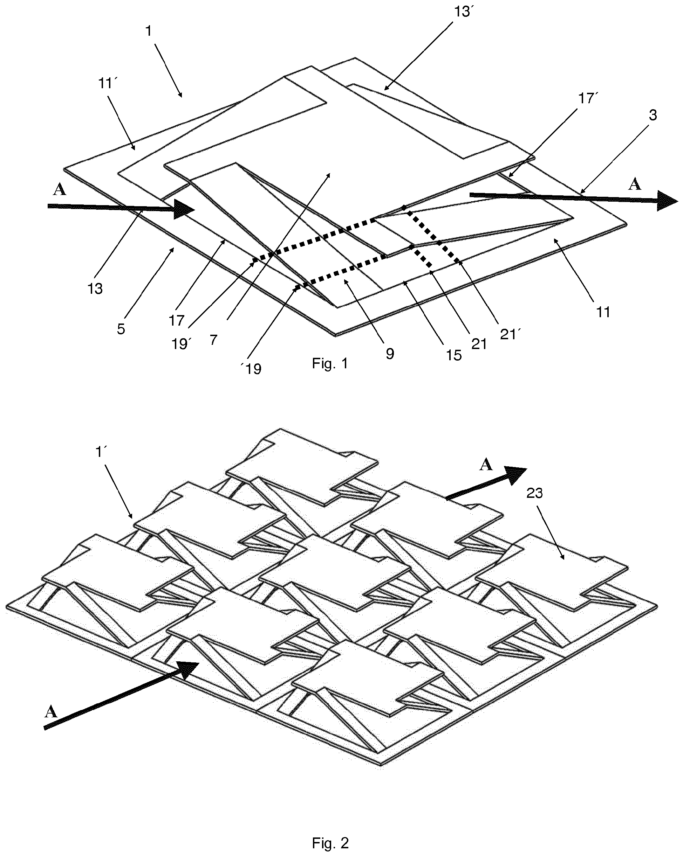

in Figur 1 ist eine erste Ausführungsform eines erfindungsgemäßen Rückseitenelements 1 dargestellt. Das Rückseitenelement 1 besteht aus einer umgeformten Materialbahn 3, wobei die Materialbahn 3 abschnittsweise in einer ersten Ebene 5 und abschnittsweise in einer zu der ersten Ebene 5 parallelen zweiten Ebene 7 angeordnet ist. In einem Übergangsbereich von der ersten Ebene 5 in die zweite Ebene 7 bildet die Materialbahn 3 Beabstandungselemente 9 aus, um die erste von der zweiten Ebene 5, 7 zu beabstanden. Zwei erste Materialbahnabschnitte 11, 11 -verlaufen dabei parallel zueinander und im rechten Winkel zu zwei parallel zueinander angeordneten zweiten Materialbahnabschnitten 13, 13'.

Dabei weist der erste erste Materialbahnabschnitt 11 ein erstes Seitenende 15 und der zweite erste Materialbahnabschnitt 11 -ein dem ersten Seitenende 15 gegenüberliegendes zweites Seitenende auf (nicht gezeigt). Der erste zweite Materialbahnabschnitt 13 weist ein rechtwinklig zu den ersten und zweiten Seitenenden 15 angeordnetes drittes Seitenende 17 und der zweite zweite Materialbahnabschnitt 13' ein dem dritten Seitenende 17 gegenüberliegendes viertes Seitenende 17' auf. Diese Ausgestaltung ist selbstverständlich ausschließlich beispielhaft zu verstehen. Die Seitenenden 17, 17' können alternativ auch kurvenförmig sein, sodass die Beabstandungselemente 9 nicht rechteckig ausgebildet sind. Auch die Spitzenecken der ersten und zweiten Ebene 5,7 können natürlich abgerundet ausgebildet werden.

Durch Umformen ist ein erster Ausschnitt der Materialbahn 3 beginnend bei dem zweiten zweiten Materialbahnabschnitt 13' in einem ersten Abstand 21 parallel zu dem ersten ersten Materialbahnabschnitt 11 bis zu einer ersten Beabstandung 19 zu dem ersten zweiten Materialbahnabschnitt 13 und ein zweiter Ausschnitt der Materialbahn 3 beginnend bei dem zweiten zweiten Materialbahnabschnitt 13' in einem zweiten Abstand 21', größer als der erste Abstand 21, parallel zu dem ersten ersten Materialbahnabschnitt 11 bis zu einer zweiten Beabstandung 19', größer als die erste Beabstandung 19, zu dem ersten zweiten Materialbahnabschnitt 13, ausgebildet.

Entsprechende Ausschnitte befinden sich jeweils um 90° gedreht, um die zweite Ebene 7 von der ersten Ebene 5 zu beabstanden und um die auf die zweite Ebene 7 wirkenden Kräfte auf die erste Ebene 5 zu übertragen. Figur 2 zeigt eine weitere Ausführungsform eines erfindungsgemäßen Rückseitenelements 1'. Diese umfasst 9 Zellen 23 gemäß dem Ausführungsbeispiel in Figur 1.

Gut ersichtlich in Figur 1 und den weiteren Figuren ist, dass durch die gebildeten Öffnungen in der Materialbahn eine optimale Luftzirkulation ermöglicht werden kann, beispielhaft dargestellt mit den Pfeilen A.

Selbstverständlich ist auch hier die Anzahl der Zellen 23 nur beispielhaft zu verstehen und diese können, symmetrisch oder asymmetrisch, in beliebiger Anzahl ausgebildet werden.Alle neun Ausschnitte weisen in Figur 2 die gleiche Drehrichtung auf. Die Drehrichtung kann aber auch unterschiedlich sein.

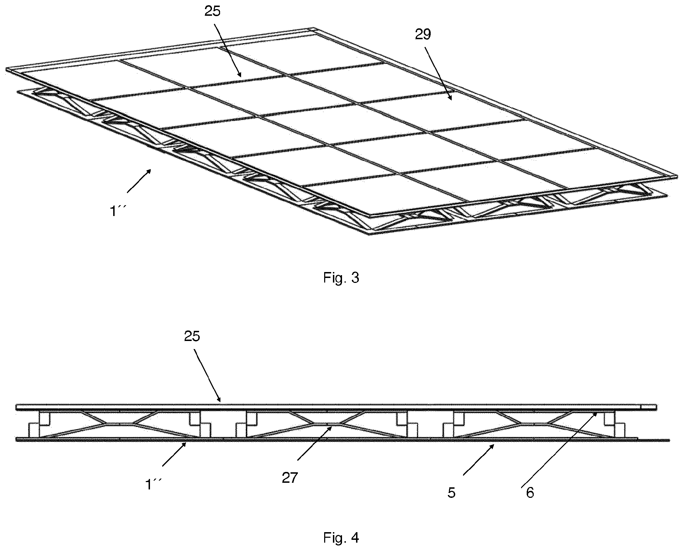

Figur 3 zeigt ein erfindungsgemäßes Solarmodul 25, welches mit einem alternativen Rückseitenelement 1" verbunden ist, in perspektivischer Ansicht.

Figur 4 zeigt das Solarmodul 25 in einer schematischen Schnittansicht.

Dabei unterscheidet sich die Ausführungsvariante des erfindungsgemäßen Rückseitenelements 1" durch eine dritte Ebene 27, die zwischen der ersten Ebene 5 und der zweiten Ebene 7 angeordnet ist. Wie bereits vorausstehend ausgeführt, ist die Geometrie und die Anzahl der von der Materialbahn 3 ausgebildeten Ebenen an den Anwendungsfall anpassbar, um den Schichtverbund 29 umfassend die Solarzellen zu Stabilisieren und zu befestigen.

Die in der voranstehenden Beschreibung, den Ansprüchen sowie den Zeichnungen offenbarten Merkmale der Erfindung können sowohl einzeln als auch in jeder beliebigen Kombination für die Verwirklichung der Erfindung in ihren verschiedenen Ausführungsformen wesentlich sein.

## Patentansprüche

1. Rückseitenelement (1, 1', 1") für ein Solarmodul (25), gebildet aus einer umgeformten, abschnittsweise eingeschnittenen, insbesondere geprägten und/oder gestanzten, Materialbahn (3), wobei die Materialbahn (3) abschnittsweise in einer ersten Ebene (5) und abschnittsweise in mindestens einer zu der ersten Ebene (5) parallelen zweiten Ebene (7) angeordnet ist, und wobei die Materialbahn (3) im Übergangsbereich von der ersten in die zweite Ebene (7) Beabstandungselemente (9) ausbildet, um die erste (5) von der zweiten Ebene (7) zu beabstanden, und wobei sich mindestens ein erster Materialbahnabschnitt (11, 11') durchgängig, insbesondere linear verlaufend, von einem ersten Seitenrand zu einem gegenüberliegenden zweiten Seitenrand der Materialbahn (3) in der ersten Ebene (5) erstreckt, wobei n erste Materialbahnabschnitte (11, 11'), mit n = 1, 2, 3, 4, 5, 6, 7, 8, 9 oder mehr, sich von einem ersten Seitenrand zu einem gegenüberliegenden zweiten Seitenrand der Materialbahn (3) in der ersten Ebene (5) erstrecken und/oder m zweite Materialbahnabschnitte (13, 13'), mit m = 1 , 2, 3, 4, 5, 6, 7, 8, 9 oder mehr, sich von einem dritten Seitenrand der Materialbahn (3) zu einem gegenüberliegenden vierten Seitenrand in der ersten Ebene (5) erstrecken, wobei die ersten und zweiten Materialbahnabschnitte (11, 11', 13, 13') rechtwinklig zueinander verlaufen, und wobei die aus der Materialbahn (3) durch Umformen und Einschneiden erzeugten Materialbahnabschnitte mindestens abschnittsweise in denjenigen Bereichen, in denen diese nicht in der selben Ebene liegen, Öffnungen des Rückseitenelements ausbilden.

2. Rückseitenelement (1, 1', 1") nach Anspruch 1, **dadurch gekennzeichnet, dass** sich die n ersten Materialbahnabschnitte (11, 11') durchgängig, von einem ersten Seitenrand zu einem gegenüberliegenden zweiten Seitenrand der Materialbahn (3) in der ersten Ebene (5) erstrecken und/oder die m zweiten Materialbahnabschnitte (13, 13') sich durchgängig von einem dritten Seitenrand der Materialbahn (3) zu einem gegenüberliegenden vierten Seitenrand in der ersten Ebene (5) erstrecken.

3. Rückseitenelement (1, 1', 1") nach einem der Ansprüche 1 oder 2, **dadurch gekennzeichnet, dass** die zweite Ebene (7) p, mit p = 1 ,2,3,4,5,6,7,8,9 oder mehr, flächige Elemente umfasst, die voneinander beabstandet angeordnet sind, und die insbesondere jeweils zwischen den n ersten (11, 11') und/oder m zweiten Materialbahnabschnitten (13, 13') der ersten Ebene (5) angeordnet sind.

4. Rückseitenelement (1, 1', 1") nach Anspruch 3, **dadurch gekennzeichnet, dass** jedes der flächigen Elemente der zweiten Ebene (7) mittels mindestens einem, insbesondere vier, Beabstandungselement (9) mit den ersten (11, 11') und/oder zweiten Materialbahnabschnitten (13, 13') der ersten Ebene (5) verbunden ist, wobei die Beabstandungselemente (9) durch Umformen der Materialbahn (3) gebildet sind.

5. Rückseitenelement (1, 1', 1") nach Anspruch 3 oder 4, **dadurch gekennzeichnet, dass** das Rückseitenelement (1, 1', 1") q, mit q = 1 ,2,3,4,5,6,7,8,9 oder mehr, Zellen (23) aufweist, wobei jede der q Zellen (23) aus zwei ersten Materialbahnabschnitten (11, 11'), zwei zweiten Materialbahnabschnitten (13, 13') in der ersten Ebene (5) und dem flächigen Element in der zweiten Ebene (7) gebildet ist.

6. Rückseitenelement (1, 1', 1") nach Anspruch 5, **dadurch gekennzeichnet, dass** ein erster erster Materialbahnabschnitt (11) ein erstes Seitenende (15), ein zweiter erster Materialbahnabschnitt (11') ein dem ersten Seitenende (15) gegenüberliegendes zweites Seitenende, ein erster zweiter Materialbahnabschnitt (13) ein rechtwinklig zu den ersten (15) und zweiten Seitenenden angeordnetes drittes Seitenende (17) und ein zweiter zweiter Materialbahnabschnitt (13') ein dem dritten Seitenende (17) gegenüberliegendes viertes Seitenende (17`) ausbildet, wobei durch Umformen ein erster Ausschnitt der Materialbahn (3) beginnend bei dem zweiten zweiten Materialbahnabschnitt (13') in einem ersten Abstand (21) parallel zu dem ersten ersten Materialbahnabschnitt (11) bis zu einer ersten Beabstandung (19) zu dem ersten zweiten Materialbahnabschnitt (13) und ein zweiter Ausschnitt der Materialbahn (3) beginnend bei dem zweiten zweiten Materialbahnabschnitt (13') in einem zweiten Abstand (21') größer als der erste Abstand (21), parallel zu dem ersten ersten Materialbahnabschnitt (11) bis zu einer zweiten Beabstandung (19') größer als die erste Beabstandung (19), zu dem ersten zweiten Materialbahnabschnitt (13) verläuft und/oder durch Umformen ein dritter Ausschnitt der Materialbahn (3) beginnend bei dem ersten zweiten Materialbahnabschnitt (13) in einem ersten Abstand parallel zu dem zweiten ersten Materialbahnabschnitt (11') bis zu einer ersten Beabstandung zu dem zweiten zweiten Materialbahnabschnitt (13') und ein vierter Ausschnitt der Materialbahn beginnend bei dem ersten zweiten Materialbahnabschnitt (13) in einem zweiten Abstand, größer als der erste Abstand, parallel zu dem zweiten ersten Materialbahnabschnitt (11') bis zu einer zweiten Beabstandung, größer als die erste Beabstandung, zu dem zweiten zweiten Materialbahnabschnitt (13') verläuft, und/oder durch Umformen ein fünfter Ausschnitt der Materialbahn (3) beginnend bei dem ersten ersten Materialbahnabschnitt (11) in einem ersten Abstand parallel zu dem ersten zweiten Materialbahnabschnitt (13) bis zu einer ersten Beabstandung zu dem zweiten ersten Materialbahnabschnitt (11') und ein sechster Ausschnitt der Materialbahn beginnend bei dem ersten ersten Materialbahnabschnitt (11) in einem zweiten Abstand, größer als der erste Abstand, parallel zu dem ersten zweiten Materialbahnabschnitt (13) bis zu einer zweiten Beabstandung, größer als die erste Beabstandung, zu dem zweiten ersten Materialbahnabschnitt (11') verläuft, und/oder durch Umformen ein siebter Ausschnitt der Materialbahn (3) beginnend bei dem zweiten ersten Materialbahnabschnitt (11') in einem ersten Abstand parallel zu dem zweiten zweiten Materialbahnabschnitt (13') bis zu einer ersten Beabstandung zu dem ersten ersten Materialbahnabschnitt (11) und ein achter Ausschnitt der Materialbahn beginnend bei dem zweiten ersten Materialbahnabschnitt (11') in einem zweiten Abstand, größer als der erste Abstand, parallel zu dem zweiten zweiten Materialbahnabschnitt (13') bis zu einer zweiten Beabstandung, größer als die erste Beabstandung, zu dem ersten ersten Materialbahnabschnitt (11) verläuft, so dass mindestens ein, insbesondere vier, Beabstandungselement (9) zur Beabstandung eines flächigen Elementes von dem ersten (11, 11') und dem zweiten Materialbahnabschnitt (13, 13') innerhalb der Zelle (23) ausgebildet ist.

7. Rückseitenelement (1, 1', 1") nach einem der vorangehenden Ansprüche, **dadurch gekennzeichnet, dass** die Materialbahn (3) aus Metall, Edelstahl, Stahlblech, Eisenblech, Kupfer, Messing, Aluminium, Kunststoff, spritzgegossenem Kunststoff und/oder teilweise umspritzten Metall besteht und/oder dieses umfasst, und insbesondere eine Stärke in einem Bereich von 0,2mm bis 4mm, vorzugsweise in einem Bereich von 0,4mm bis 2mm, besonders bevorzugt in einem Bereich von 0,5mm bis 1 mm aufweist.

8. Rückseitenelement nach einem der vorangehenden Ansprüche, **dadurch gekennzeichnet, dass** das Rückseitenelement in der ersten Ebene und/oder in der zweiten Ebene mindestens eine Aussparung oder Ausformung aufweist, um eine Anschlussdose für eine elektrische Kontaktierung einer Solarzelle und/oder einer Solarzellenmatrix aufzunehmen und/oder um eine elektrische Kontaktierung einer Solarzelle und/oder einer Solarzellenmatrix, insbesondere der frei in der Aussparung liegenden Bereich der Querverbinder einer Solarzelle und/oder einer Solarzellenmatrix, zu ermöglichen und/oder dass Halteösen, Klammern, Kabelführungen und/oder Kabelkanäle für die elektrische Kontaktierung der Solarzellen umfasst sind und/oder das Rückseitenelement Aussparungen im Randbereich aufweist, um einen sicheren Transport von elektrischen Kontaktelementen, insbesondere von Kabeln und/oder Steckern, zu ermöglichen sowie deren Befestigung nach der Solarmodulmontage zu vereinfachen/gewährleisten.

9. Rückseitenelement (1") nach einem der vorangehenden Ansprüche, **dadurch gekennzeichnet, dass** die Materialbahn (3) Verstärkungselemente umfasst, insbesondere angeordnet im Verbindungsbereich des Rückseitenelements(1") mit einer Unterkonstruktion und/oder dass die zweite Ebene (7), insbesondere mindestens ein flächiges Element der zweiten Ebene (7), derart umgeformt ist, dass eine dritte Ebene (27) ausgebildet ist und/oder eine umgeformte, insbesondere geprägte, Oberflächenstruktur aufweist, die insbesondere wabenförmig ist.

10. Rückseitenelement nach einem der vorangehenden Ansprüche, **dadurch gekennzeichnet, dass** mindestens ein äußerer Rand, insbesondere zwei gegenüberliegende Ränder, vorzugsweise alle Ränder, des Rückseitenelements durch Abkanten umgeformt ist bzw. sind und insbesondere ein zur Versteifung geeignetes Profil ausbilden, insbesondere eine Kastenprofil und/oder dass mindestens ein äußerer Rand, insbesondere zwei gegenüberliegende Ränder, vorzugsweise alle Ränder, des Rückseitenelements Aussparungen und/oder Ausformungen umfassen, die mit komplementären Aussparungen und/oder Ausformungen eines weiteren Rückseitenelements in Wirkverbindung bringbar sind oder stehen, wobei die Aussparungen und/oder Ausformungen ausgelegt und eingerichtet sind, um zwei Rückseitenelemente gegeneinander auszurichten und/oder dass mindestens ein äußerer Rand, insbesondere zwei gegenüberliegende Ränder, vorzugsweise alle Ränder, des Rückseitenelements Befestigungseinrichtungen und/ oder Aussparungen, insbesondere in Form von Bohrungen, aufweisen, ausgelegt und eingerichtet, um das Rückseitenelement mit einem weiteren Element und/oder der Unterkonstruktion nicht lösbar oder lösbar zu verbinden und/oder dass das Rückseitenelement aus einer umgeformten Materialbahn besteht.

11. Solarmodul (25) umfassend mindestens zwei Solarzellen und mindestens ein auf der Rückseite der Solarzellen angeordnetes Rückseitenelement (1") gemäß einem der vorangehenden Ansprüche, wobei die zweite Ebene (7) des mindestens einen Rückseitenelements (1") der Rückseite der Solarzellen zugewandt angeordnet ist.

12. Solarmodul (25) nach Anspruch 11, **dadurch gekennzeichnet, dass** das Solarmodul (25) keinen Modulrahmen und kein Montagesystem umfassend Backrails umfasst.

13. Solarmodul nach einem der Ansprüche 11 oder 12, **dadurch gekennzeichnet, dass** jeweils mindestens ein flächiges Element und/oder mindestens eine Zelle, insbesondere r flächige Elemente und/oder Zellen, mit r = 1 , 2, 3, 4, 5, 6, 7, 8, 9 oder mehr, vorzugsweise mit r = 1 , 4, 9, oder 16, in der zweiten Ebene des Rückseitenelements zumindest teilweise überlappend, insbesondere deckungsgleich mit jeweils mindestens einer der Solarzellen der Solarzellenmatrix des Solarmoduls angeordnet ist, so dass der Rückseite jeder der Solarzellen r flächige Elemente und/ oder Zellen gegenüberliegen, und/oder dass das Rückseitenelement die gesamte Rückseite des Solarmoduls überdeckt oder mindestens ein oder mehr Rückseitenelemente einen Teilbereich der Rückseite des Solarmoduls überdeckt.

14. Verfahren zur Herstellung eines Solarmoduls umfassend die folgenden Schritte in dieser Reihenfolge:
a) Bereitstellen einer Substratplatte;
b) Anordnen von mindestens zwei elektrisch miteinander kontaktierten Solarzellen auf der Substratplatte;
c) Anordnen mindestens einer rückseitigen Laminatschicht auf der Rückseite der Solarzelle;
d) Anordnen mindestens eines Rückseitenelements nach einem der Ansprüche 1 bis 10 auf der rückseitigen Laminatschicht; und
e) Laminieren des Solarmoduls, optional weiterhin umfassend die nachfolgenden Schritte nach Schritt e), insbesondere in dieser Reihenfolge:
f) Trimmen des Laminats; und
g) Setzen der Anschlussdosen zur elektrischen Kontaktierung des Solarmoduls.

15. Verfahren zur Herstellung eines Solarmoduls umfassend die folgenden Schritte in dieser Reihenfolge:
aa) Bereitstellen einer Substratplatte;
ab) Anordnen von mindestens zwei elektrisch miteinander kontaktierten Solarzellen auf der Substratplatte;
ac) Anordnen mindestens einer rückseitigen Laminatschicht auf der Rückseite der Solarzelle;
ad) Laminieren mindestens der rückseitigen Laminatschicht;
ae) optionales Trimmen des Laminats;
af) optionales Setzen der Anschlussdosen zur elektrischen Kontaktierung des Solarmoduls und Anordnen mindestens eines Rückseitenelements nach einem der Ansprüche 1 bis 10 auf der rückseitigen Laminatschicht und Verbinden des Rückseitenelements mit der rückseitigen Laminatschicht, insbesondere durch Silikon oder Polyurethan-Kleber; oder
ag) Anordnen mindestens eines Rückseitenelements nach einem der Ansprüche 1 bis 10 auf der rückseitigen Laminatschicht und Verbinden des Rückseitenelements mit der rückseitigen Laminatschicht, insbesondere durch Silikon oder Polyurethan-Kleber, und Setzen der Anschlussdosen zur elektrischen Kontaktierung des Solarmoduls.

## Claims

1. A rear face element (1, 1', 1") for a solar module (25) formed from a material sheet (3) that is shaped, cut into in some sections, in particular embossed and/or stamped, wherein some sections of the material sheet (3) are arranged in a first plane (5) and some sections are arranged in at least one second plane (7) parallel to the first plane (5), and wherein the material sheet (3) forms spacing elements (9) in a transitional region from the first plane (5) to the second plane (7) in order to keep the first plane (5) at a spacing distance from the second plane (7), and wherein at least one first material sheet section (11, 11') extends continuously, in particular in a linear manner, from a first lateral edge to an opposite second lateral edge of the material sheet (3) in the first plane (5), wherein n first material sheet sections (11, 11'), where n = 1, 2, 3, 4, 5, 6, 7, 8, 9 or more, extend from a first side edge to an opposite second side edge of the material sheet (3) in the first plane (5) and/or m second material sheet sections (13, 13'), where m = 1, 2, 3, 4, 5, 6, 7, 8, 9 or more, extend from a third side edge of the material sheet (3) to an opposite fourth side edge in the first plane (5), wherein the first and second material sheet sections (11, 11', 13, 13') extend at right angles to one another, and wherein the material sheet sections produced from the material sheet (3) by shaping and cutting-in form openings in the rear face element at least in some sections, in those regions in which they do not lie in the same plane.

2. The rear face element (1, 1', 1") as claimed in claim 1, **characterized in that** the n first material sheet sections (11, 11') extend continuously, from a first side edge to an opposite second side edge of the material sheet (3), in the first plane (5) and/or the m second materials sheet sections (13, 13') extend continuously from a third side edge of the material sheet (3) to an opposite forth side edge in the first plane (5).

3. The rear face element (1, 1', 1") as claimed in either of claims 1 and 2, **characterized in that** the second plane (7) p, where p = 1, 2, 3, 4, 5, 6, 7, 8, 9 or more, comprises sheet-like elements which are arranged at a spacing distance from one another, and which in particular are arranged in each case between the n first material sheet sections (11, 11') and/or m second material sheet sections (13, 13') of the first plane (5).

4. The rear face element (1, 1', 1") as claimed in one of the preceding claims, **characterized in that** each of the sheet-like elements of the second plane (7) is connected to the first (11, 11') and/or second material sheet sections (13, 13') of the first plane (5) by means of one spacing element (9), in particular four spacing elements (9), the spacing elements (9) being formed by cutting in and shaping the material sheet (3).

5. The rear face element (1, 1', 1") as claimed in one of the preceding claims, **characterized in that** the rear face element (1, 1', 1") has q cells (23), where q = 1, 2, 3, 4, 5, 6, 7, 8, 9 or more, wherein each of the q cells (23) is formed from two first material sheet sections (11, 11'), two second material sheet sections (13, 13') in the first plane (5) and a sheet-like element in the second plane (7).

6. The rear face element (1, 1', 1") as claimed in claim 5, **characterized in that** a first first material sheet section (11) forms a first side end (15), a second first material sheet section (11') forms a second side end, opposite from the first side end (15), a first second material sheet section (13) forms a third side end (17), arranged at right angles to the first (15) and second side ends, and a second second material sheet section (13') forms a fourth side end (17'), opposite from the third side end (17), wherein, by shaping, a first cutout of the material sheet (3), beginning with the second second material sheet section (13'), extends at a first distance (21) parallel to the first first material sheet section (11) up to a first spacing distance (19) from the first second material sheet section (13) and a second cutout of the material sheet (3), beginning with the second second material sheet section (13'), extends at a second distance (21'), greater than the first distance (21), parallel to the first first material sheet section (11) up to a second spacing distance (19'), greater than the first spacing distance (19), from the first second material sheet section (13) and/or, by shaping, a third cutout of the material sheet (3), beginning with the first second material sheet section (13), extends at a first distance parallel to the second first material sheet section (11') up to a first spacing distance from the second second material sheet section (13') and a fourth cutout of the material sheet (3), beginning with the first second material sheet section (13), extends at a second distance, greater than the first distance, parallel to the second first material sheet section (11') up to a second spacing distance, greater than the first spacing distance, from the second second material sheet section (13') and/or, by shaping, a fifth cutout of the material sheet (3) , beginning with the first first material sheet section (11), extends at a first distance parallel to the first second material sheet section (13) up to a first spacing distance from the second first material sheet section (1 1') and a sixth cutout of the material sheet (3), beginning with the first first material sheet section (11), extends at a second distance, greater than the first distance, parallel to the first second material sheet section (13) up to a second spacing distance, greater than the first spacing distance, from the second first material sheet section (11') and/or, by shaping, a seventh cutout of the material sheet (3), beginning with the second first material sheet section (11'), extends at a first distance parallel to the second second material sheet section (13'), up to a first spacing distance from the first first material sheet section and an eigth cutout of the material sheet (3), beginning with the second first material sheet section (11'), extends at a second distance, greater than the first distance, parallel to the second second material sheet section (13') up to a second spacing distance, greater than the first spacing distance, from the first first material sheet section (11), and so at least one spacing element (9), in particular four spacing elements (9), is/are formed for keeping the sheet-like element at a spacing distance from the first (11, 11') and second material sheet section (13, 13') within the cell (23).

7. The rear face element (1, 1', 1") as claimed in one of the preceding claims, **characterized in that** the material sheet (3) consists of and/or comprises metal, high-grade steel, steel sheet, iron sheet, copper, brass, aluminum, plastic, injection-molded plastic and/or partially encapsulated metal, and in particular has a thickness in a range from 0.2 mm to 4 mm, preferably in a range from 0.4 mm to 2 mm, particularly preferably in a range from 0.5 mm to 1 mm.

8. The rear face element as claimed in one of the preceding claims, **characterized in that** the rear face element has at least one clearance or formation in the first plane and/or in the second plane, in order to receive a connection socket for electrical contact of a solar cell and/or a solar cell matrix and/or to allow electrical contact of a solar cell and/or a solar cell matrix, in particular the region exposed in the clearance of the cross-connectors of a solar cell and/or a solar cell matrix and/or that retaining eyelets, clamps, cable guides and/or cable ducts for the electrical contacting of the solar cells are comprised and/or the rear face element has clearances in the edge region in order to allow secure transport of electrical contact elements, in particular cables and/or plugs, and to simplify/ensure fastening thereof after fitting of the module.

9. The rear face element (1") as claimed in one of the preceding claims, **characterized in that** the metal sheet (3) comprises reinforcing elements, in particular arranged in the connecting region of the rear face element (1") of the solar module to the substructure and/or that the second plane (7), in particular at least one sheet-like element of the second plane (7), is shaped in such a way that a third plane (27) is formed and/or has a shaped, in particular embossed, surface structure, in particular is honeycomb-shaped.

10. The rear face element as claimed in one of the preceding claims, **characterized in that** at least one outer edge, in particular two opposite outer edges, preferably all the edges, of the rear face element is or are shaped by flanging and in particular form a profile suitable for stiffening, in particular a box profile and/or that at least one outer edge, in particular two opposite outer edges, preferably all the edges, of the rear face element comprises or comprise clearances and/or formations that can be brought into or are in operative connection with comparable clearances and/or formations of a further rear face element, the clearances and/or formations being designed and set up for aligning two rear face elements with one another and/or that at least one outer edge, in particular two opposite edges, preferably all the edges, of the rear face element have fastening devices and/or clearances, in particular in the form of bores, designed and set up for connecting the rear face elements unreleasably or releasably to a further element and/or the substructure and/or that the rear face element consists of a shaped material sheet.

11. A solar module (25), comprising at least two solar cells and at least one rear face element (1") as claimed in one of the preceding claims arranged on the rear face of the solar cells, the second plane (7) of the at least one rear face element (1") being arranged facing the rear face of the solar cells.

12. The solar module (25) as claimed in claim 11, **characterized in that** the solar module (25) does not comprise a module frame or a fitting system comprising backrails.

13. The solar module as claimed in either of claims 11 and 12, **characterized in that** in each case at least one sheet-like element and/or at least one cell, in particular r sheet-like elements and/or cells, where r = 1, 2, 3, 4, 5, 6, 7, 8, 9 or more , preferably where r = 1, 4, 9 or 16, is arranged in the second plane of the rear face element at least partially overlapping, in particular congruent, with in each case at least one of the solar cells of the solar cell matrix of the solar module, and so r sheet-like elements and/or cells lie opposite the rear face of each of the solar cells and/or that the rear face element covers over the entire rear face of the solar module or at least one or more rear face element s cover(s) a partial region of the rear face of the solar module.

14. A method for producing a solar module comprising the following steps, in particular in this sequence:
a) providing a substrate panel;
b) arranging at least two solar cells that are electrically contacted with respect to one another on the substrate panel;
c) arranging at least one rear-side laminate layer on the rear face of the solar cell;
d) arranging at least one rear face element as claimed in one of claims 1 to 10 on the rear-side laminate layer; and
e) laminating the solar module, optionally also comprising the following steps after step e), in particular in this sequence:
f) trimming the laminate; and
g) placing the connection sockets for electrical contacting of the solar module.

15. A method for producing a solar module comprising the following steps, in particular in this sequence:
aa) providing a substrate panel;
ab) arranging at least two solar cells that are electrically contacted with respect to one another on the substrate panel;
ac) arranging at least one rear-side laminate layer on the rear face of the solar cell;
ad) laminating at least the rear-side laminate layer;
ae) optionally trimming the laminate;
af) optionally placing the connection sockets for the electrical contacting of the solar module and arranging at least one rear face element as claimed in one of claims 1 to 10 on the rear-side laminate layer and connecting the rear face element to the rear-side laminate layer, in particular by silicone or polyurethane adhesive; or
ag) arranging at least one rear face element as claimed in one of claims 1 to 10 on the rear-side laminate layer and connecting the rear face element to the rear-side laminate layer, in particular by silicone or polyurethane adhesive, and placing the connection sockets for the electrical contacting of the solar module.

## Revendications

1. Un élément arrière (1, 1', 1") pour un module solaire (25), constitué d'une bande de matière (3) formée, découpée en sections, en particulier gaufrée et/ou poinçonnée, dans lequel la bande de matière (3) est disposée en sections dans un premier plan (5) et en sections dans au moins un deuxième plan (7) parallèle au premier plan (5), et dans lequel la bande de matière (3) forme des éléments d'espacement (9) dans la zone de transition du premier au deuxième plan (7) pour espacer le premier (5) du deuxième plan (7), et dans lequel au moins une première section de bande de matière (11, 11') s'étend continuellement, en particulier linéairement, d'un premier bord latéral à un deuxième bord latéral opposé de la bande de matière (3) dans le premier plan (5), dans lequel n premières sections de bande de matière (11, 11'), avec n = 1, 2, 3, 4, 5, 6, 7, 8, 9 ou plus, s'étendent d'un premier bord latéral à un deuxième bord latéral opposé de la bande de matière (3) dans le premier plan (5) et/ou m deuxièmes sections de bande de matière (13, 13'), avec m = 1, 2, 3, 4, 5, 6, 7, 8, 9 ou plus, s'étendent d'un troisième bord latéral de la bande matérielle (3) à un quatrième bord latéral opposé dans le premier plan (5), dans lequel les première et deuxième sections de bande de matière (11, 11', 13, 13') sont perpendiculaires l'une à l'autre, et dans lequel les sections de bande de matière créées à partir de la bande de matière (3) en formant et en coupant forment au moins en sections des ouvertures de l'élément arrière dans les zones où elles ne sont pas dans le même plan.

2. L'élément arrière (1, 1', 1") selon la revendication 1, **caractérisé en ce que** les n premières sections d'bande de matière (11, 11') s'étendent continuellement d'un premier bord latéral à un deuxième bord latéral opposé de la bande de matière (3) dans le premier plan (5) et/ou les m deuxièmes sections de bande de matière (13, 13') s'étendent continuellement d'un troisième bord latéral de la bande de matière (3) à un quatrième bord latéral opposé dans le premier plan (5).

3. L'élément arrière (1, 1', 1") selon l'une quelconque des revendications 1 ou 2, **caractérisé en ce que** le deuxième plan (7) comprend p, avec p = 1,2,3,4,5,6,7,8,9 ou plus, éléments plats qui sont espacés les uns des autres et qui sont disposés en particulier entre les n premières (11, 11') et/ou m deuxièmes sections de bande (13, 13') du premier plan (5).

4. L'élément arrière (1, 1', 1") selon la revendication 3, **caractérisé en ce que** chacun des éléments plats du deuxième plan (7) est relié aux premières (11, 11') et/ou deuxièmes sections (13, 13') de bande de matière du premier plan (5) au moyen d'au moins un, en particulier quatre, élément d'espacement (9), dans lequel les éléments d'espacement (9) sont formés par formage de la bande de matière (3).

5. L'élément arrière (1, 1', 1") selon la revendication 3 ou 4, **caractérisé en ce que** l'élément arrière (1, 1', 1") comporte q, avec q = 1 ,2,3,4,5,6,7,8,9 ou plus, cellules (23), chacune des q cellules (23) étant formée de deux premières sections de bande de matière (11, 11'), de deux deuxièmes sections de bande de matière (13, 13') dans le premier plan (5) et de l'élément plat dans le deuxième plan (7).

6. L'élément arrière (1, 1', 1") selon la revendication 5, **caractérisé en ce qu'**une première première section de bande de matière (11) a une première extrémité latérale (15), une deuxième première section de bande de matière (11') a une deuxième extrémité latérale opposée à la première extrémité latérale (15), une première deuxième section de bande de matière (13) forme une troisième extrémité latérale (17) disposée perpendiculairement à la première (15) et à la deuxième extrémité latérale (13') et une deuxième deuxième section de bande de matière (13') forme une quatrième extrémité latérale opposée à la troisième extrémité latérale (17), dans lequel, en transformant, une première section de bande de matériau (3) est à partir de la deuxième deuxième section de bande de matière (13') à une première distance (21) parallèle à la première première section de bande de matière (11) jusqu'à un premier espacement (19) à la première deuxième section de bande de matière (13) et une deuxième section de bande de matière (3) est à partir de la deuxième deuxième section de bande de matière (13') à une deuxième distance (21') supérieure à la première distance (21) parallèle à la première première section de bande de matière (11) jusqu'à un deuxième espacement (19') supérieure au premier espacement (19) à la première deuxième section de bande de matière (13) et/ou, en transformant, une troisième section de bande de matière (3) est à partir de la première deuxième section de bande de matière (13) à une première distance parallèle à la deuxième première section de bande de matière (11') jusqu'à un premier espacement à la deuxième deuxième section de bande de matière (13') et une quatrième section de bande de matière est à partir de première deuxième section de bande de matière (13) à une deuxième distance, supérieure à la première distance, parallèle à la deuxième première section de bande de matière (11') jusqu'à un deuxième espacement, supérieure au premier espacement, à la deuxième deuxième section de bande de matière (13'), et/ou, en transformant, une cinquième section de bande de matière (3 est à partir de la première première section de bande de matière (11) à une première distance parallèle à la première deuxième section de bande de matière (13) jusqu'à un premier espacement à la deuxième première section de bande de matière (11') et une sixième section de bande de matière est à partir de la première première section de bande de matière (11) à une deuxième distance, supérieure à la première distance, parallèle à la première deuxième section de bande de matière (13) jusqu'à un deuxième espacement, supérieure au premier espacement, à la deuxième première section de bande de matière (11'), et/ou, en transformant, une septième section de bande de matière (3) est à partir de la deuxième première section de bande de matière (11') à une première distance parallèle à la deuxième deuxième section de bande de matière (13') jusqu'à un premier espacement à la première première section d'bande de matière (11) et une huitième section de bande de matière est à partir de la deuxième première section de bande de matière (11') à une deuxième distance, supérieure à la première distance, parallèle à la deuxième deuxième section de bande de matière (13') jusqu'à un deuxième espacement, supérieur au premier espacement, à la première première section de bande de matière (11), de sorte qu'au moins un, en particulier quatre, élément d'espacement (9) est formé pour espacer un élément plat des première (11, 11') et deuxième sections de bande de matière (13, 13') à l'intérieur de la cellule (23).

7. L'élément arrière (1, 1', 1") selon l'une quelconque des revendications précédentes, **caractérisé en ce que** la bande de matière (3) consiste et/ou comprend du métal, de l'acier inoxydable, de la tôle d'acier, de la tôle, du cuivre, du laiton, de l'aluminium, du plastique, du plastique moulé par injection et/ou du métal partiellement surmoulé, et a en particulier une épaisseur dans une plage de 0,2 mm et 4 mm, de préférence dans une plage de 0,4 mm et 2 mm, particulièrement préférable dans une plage de 0,5 mm à 1 mm.

8. L'élément arrière selon l'une quelconque des revendications précédentes, **caractérisé en ce que** l'élément arrière présente au moins un évidement ou une forme au premier plan et/ou au deuxième plan pour recevoir une boîte de jonction pour un contact électrique d'une cellule solaire et/ou d'une matrice de cellules solaires et/ou pour permettre un contact électrique d'une cellule solaire et/ou d'une matrice de cellules solaires, en particulier des zones des connecteurs transversaux d'une cellule solaire et/ou d'une matrice de cellules solaires exposées dans l'évidement et/ou que des œillets de retenue, des pinces, des guides câbles et/ou des conduits de câbles pour le contact électrique des cellules solaires sont inclus et/ou que l'élément arrière a des évidements dans la zone de bord afin de permettre le transport en toute sécurité des éléments de contact électrique, en particulier des câbles et/ou des fiches, et de simplifier/assurer leur fixation après l'installation du module solaire.

9. L'élément arrière (1") selon l'une quelconque des revendications précédentes, **caractérisé en ce que** la bande de matière (3) comprend des éléments de renforcement, disposés en particulier dans la zone de liaison de l'élément arrière (1") avec une sous-structure et/ou que le deuxième plan (7), en particulier au moins un élément plat du deuxième plan (7), est transformé de telle sorte qu'un troisième plan (27) est formé et/ou a une structure de surface en relief, en particulier gaufrée, qui est en particulier en forme de nid d'abeille.

10. L'élément arrière selon l'une quelconque des revendications précédentes, **caractérisé en ce qu'**au moins un bord extérieur, en particulier deux bords opposés, de préférence tous les bords, de l'élément arrière est ou sont transformés par pliage et forment en particulièrement un profil approprié au raidissement, en particulier un profil en caisson et/ou qu'au moins un bord extérieur, en particulier deux bords opposés, de préférence tous les bords, de l'élément arrière comprennent des évidements et/ou des formes qui peuvent être placés ou sont placés en contact actif avec des évidements et/ou des formes complémentaires d'un autre élément arrière, dans lequel les évidements et/ou les formes sont conçus et adaptés de manière à aligner deux éléments arrière l'un par rapport à l'autre et/ou qu'au moins un bord extérieur, en particulier deux bords opposés, de préférence tous les bords de l'élément arrière présentent des dispositifs de fixation et/ou des évidements, en particulier sous forme de trous, conçus et adaptés pour relier l'élément arrière à un autre élément et/ou à la sous-structure de manière non détachable ou détachable et/ou que l'élément arrière consiste d'une bande de matière transformé.

11. Un module solaire (25) comprenant au moins deux cellules solaires et au moins un élément arrière (1") selon l'une quelconque des revendications précédentes et disposé à l'arrière des cellules solaires, dans lequel le deuxième plan (7) d'au moins un élément arrière (1") est disposé face à l'arrière des cellules solaires.

12. Le module solaire (25) selon la revendication 11, **caractérisé en ce que** le module solaire (25) ne comprend pas de cadre de module et de système de montage comprenant des rails arrière.

13. Le module solaire selon l'une quelconque des revendications 11 ou 12, **caractérisé en ce que** respectivement au moins un élément plat et/ou au moins une cellule, en particulier r éléments plats et/ou cellules, avec r = 1, 2, 3, 4, 5, 6, 7, 8, 9 ou plus, de préférence r = 1, 4, 9 ou 16, se chevauchent au moins partiellement, en particulier coïncident, dans le deuxième plan de l'élément arrière avec au moins une des cellules solaires de la matrice de cellules solaires du module solaire, de sorte que l'arrière de chacune des cellules solaires soit opposé à r éléments plats et/ou cellules, et/ou que l'élément arrière couvre tout l'arrière du module solairè ou au moins un ou plusieurs éléments arrière couvrent une partie de l'arrière du module solaire.

14. Un procédé de fabrication d'un module solaire comprenant les étapes suivantes dans cet ordre :
a) fournir un panneau de substrat ;
b) disposer au moins deux cellules solaires en contact électrique sur le panneau de substrat ;
c) disposer au moins une couche de stratifié arrière à l'arrière de la cellule solaire ;
d) disposer au moins un élément arrière selon l'une des revendications 1 à 10 sur la couche stratifiée arrière ; et
e) laminer le module solaire, comprenant optionnellement encore les étapes suivantes après l'étape e), en particulier dans cet ordre :
f) ajuster le stratifié ; et
g) fixer des boîtes de jonction pour la mise en contact électrique du module solaire.

15. Un procédé de fabrication d'un module solaire comprenant les étapes suivantes dans cet ordre :
aa) fournir un panneau de substrat ;
ab) disposer au moins deux cellules solaires en contact électrique sur le panneau de substrat ;
ac) disposer au moins une couche stratifié arrière à l'arrière de la cellule solaire ;
ad) laminer au moins la couche stratifiée arrière ;
ae) optionnellement ajuster le stratifié ;
af) optionnellement fixer des boîtes de jonction pour la mise en contact électrique du module solaire et disposer au moins un élément arrière selon l'une des revendications 1 à 10 sur la couche stratifiée arrière et relier l'élément arrière avec la couche stratifiée arrière, en particulier au moyen d'un adhésif silicone ou
polyuréthane ; ou
ag) disposer au moins un élément arrière selon l'une des revendications 1 à 10 sur la couche stratifiée arrière et relier l'élément arrière à la couche stratifiée arrière,
en particulier au moyen d'un adhésif silicone ou polyuréthane, et fixer les boîtes de jonction pour la mise en contact électrique du module solaire.
